# FASCICULE DE BREVET EUROPEEN

(11) **EP 2 505 041 B1**
(45) Date de publication et mention de la délivrance du brevet: **18.09.2013**
(21) Numéro de dépôt: 10784500.0
(22) Date de dépôt: 23.11.2010
(51) Int. Cl.: H05H 1/24

(54) **PROCÉDÉ ET DISPOSITIF DE POLARISATION D'UNE ÉLECTRODE DBD**
VERFAHREN UND VORRICHTUNG ZUR POLARISIERUNG EINER DBD-ELEKTRODE
METHOD AND DEVICE FOR POLARISING A DBD ELECTRODE

(30) Priorité: 24.11.2009 EP 09176940; 12.02.2010 EP 10153448
(43) Date de publication de la demande: 03.10.2012
(73) Titulaire: AGC Glass Europe, 1170 Bruxelles (Watermael-Boitsfort) (BE); Leclercq, Joseph, 6040 Jumet (BE)
(72) Inventeur: MICHEL, Eric, B-6040 Jumet (BE); TIXHON, Eric, B-6040 Jumet (BE)
(74) Mandataire: Larangé, Françoise
(86) Numéro de dépôt international: PCT/EP2010/068049
(87) Numéro de publication internationale: WO 2011/064217

(56) Documents cités:
- EP-A1- 2 180 768
- CA-A1- 2 506 787
- US-B1- 6 416 633

## Description

L'invention se rapporte à un procédé pour le dépôt de couches sur un substrat inorganique afin d'en modifier les propriétés. En particulier, l'invention vise le dépôt de couches sur des plaques de verre. Dans le contexte de l'invention, le traitement de surface d'un substrat et le dépôt de couches sur un substrat ont une signification identique.

L'invention se rapporte aussi à une installation permettant d'appliquer le procédé en question, notamment en continu.

Différents procédés sont utilisés pour déposer des revêtements en couches minces sur des substrats divers. Ils se différencient notamment par la façon dont l'énergie est engendrée pour la production et/ou la liaison au support des composés souhaités.

Les dépôts de revêtements en couches minces touchent diverses applications, comme l'électronique, les revêtements anti-corrosion et tribologiques, tels que les couches réfractaires (nitrures, carbures et oxydes de titane ou d'aluminium), les revêtements à propriétés optiques (anti-réfléchissants, anti-solaires, filtres, etc.), les revêtements procurant d'autres propriétés de surface particulières(anti-microbienne,auto-nettoyante, hydrophile, hydrophobe etc.), les couches d'oxyde d'étain conductrices pour applications diverses (photovoltaïques, LED, OLED, organique photovoltaïque etc.).

Les substrats concernés peuvent être de divers types: verre, acier, céramique, polymères organiques, thermoplastiques, etc.

On distingue principalement quatre techniques de dépôt de couches minces applicables en particulier dans le domaine verrier : le sol-gel, le magnétron, le spray pyrolytique, et le dépôt chimique en phase vapeur (CVD).

La CVD consiste à envoyer sur un substrat chaud des réactifs chimiques ou précurseurs, préalablement vaporisés, et qui se décomposent par pyrolyse au contact du substrat chaud.

Ce procédé est couramment appliqué « on-line » lors de la production du verre flotté. On obtient ainsi des couches minces (de l'ordre de quelques dizaines ou centaines de nm), notamment d'oxydes. Les couches obtenues sont denses, d'une grande pureté et généralement très stables chimiquement ainsi que mécaniquement. Les vitesses de dépôt sont élevées.

Cependant, la gamme de matériaux pouvant être déposés est limitée car il est difficile de trouver des précurseurs volatilisables et qui vont pyrolyser dans la gamme de températures accessibles aux verriers (500-750°C). Une possibilité de s'affranchir de la température du substrat et donc d'élargir la gamme des précurseurs utilisables en CVD et, par conséquent, la gamme de matériaux déposable, est de combiner la CVD classique (éventuellement à plus basse température) avec un dispositif plasma.

La PECVD (pour « Plasma Enhanced Chemical Vapour Deposition ») peut s'effectuer à l'aide de n'importe quel plasma : plasmas froids (hors équilibre) ou plasmas thermiques (en équilibre). Les plasmas froids sont généralement préférés. Les espèces actives du plasma (électrons, ions, métastable, etc.) possèdent typiquement des énergies de plusieurs électronvolts (eV) et peuvent ainsi provoquer la dissociation ou l'activation des précurseurs chimiques.

Pour maintenir le plasma hors équilibre, il est souvent nécessaire de travailler à pression réduite. La plupart des techniques connues de PECVD utilisent donc des plasmas à basse pression. Cependant, pour appliquer ce procédé à des fins industrielles, il est nécessaire de minimiser les coûts. Il y a donc un intérêt croissant de la part des industriels pour transférer les technologies plasma basses pressions vers des technologies plasma fonctionnant dans une gamme de pression proche de la pression atmosphérique.

On distingue par ailleurs dans les procédés de dépôt sous plasma différents régimes : le régime sous plasma homogène (connu sous le nom de « glow dischage plasma»). Il permet des dépôts très homogènes et requiert un niveau d'énergie relativement bas. En revanche, il est plus lent, il faut le cantonner à une gamme de fréquence plus restreinte pour qu'il reste stable et il limite la composition des espèces que l'on peut déposer.

Si l'on augmente l'énergie du plasma, on risque de provoquer l'apparition d'arcs électriques. L'interposition d'un diélectrique entre les électrodes permet de maintenir un régime intermédiaire entre la « glow discharge » et l'apparition d'arcs : on parle de régime « filamentaire ». Les « filaments », éminemment instables, véhiculent une énergie élevée et permettent donc de raccourcir d'autant le temps de traitement, c'est-à-dire d'accélérer le défilement du substrat. Par ailleurs, du fait même de l'action aléatoire des filaments, on obtient paradoxalement un taux de répartition très homogène des matériaux déposés. La mise en oeuvre de ces deux technologies a été longuement décrite dans les ouvrages et est donc connue de l'homme du métier.

On a cherché à allier les potentialités des procédés de traitement par CVD classique avec les potentialités d'un procédé plasma à pression atmosphérique. Le choix du Demandeur s'est porté sur l'utilisation d'une décharge à barrière diélectrique (DBD). Cette dernière a en effet l'avantage, par rapport aux autres procédés plasma, de fonctionner tant à basse pression qu'à pression atmosphérique et de permettre un traitement continu sur de grandes surfaces, ce qui implique que l'on puisse développer des puissances wattées de l'ordre du MégaWatt.

Lors de la formation du dépôt par le procédé DBD, on constate que le dépôt est symétrique, c'est à dire que la quantité de matière déposée sur le substrat et sur l'électrode est la même par unité de temps.

Le dépôt sur l'électrode est non désiré et constitue un frein important pour l'exploitation de ce procédé dans les applications industrielles de forte capacité, car il perturbe rapidement la qualité de la couche déposée sur le substrat cible par la modification de l'espace inter-électrode qui constitue une donnée essentielle pour garantir la formation d'une couche homogène.

Des nettoyages fréquents seraient donc indispensables, entraînant des pertes de productivité ainsi qu'un dédoublement des installations de dépôt de couche dans les procédés de production continue pour permettre un nettoyage alterné.

Or, on constate que les espèces chimiques formées dans le plasma sont notamment sous forme d'ions positifs et négatifs. Cela revient à dire que les espèces chimiques qui interviennent dans le processus de formation de la couche sur le matériau à revêtir ne sont pas électriquement neutres.

Un premier but de l'invention est de réduire, voire éliminer, les dépôts parasites sur l'électrode portée à la haute tension en polarisant cette dernière.

Un autre but est d'améliorer le rendement de procédés de dépôt de couches en augmentant la tension sur l'alternance durant laquelle les espèces désirées se déposent sur un substrat.

Un premier objet de l'invention est un procédé pour le dépôt d'une couche sur un substrat inorganique caractérisé en ce qu'il comprend les opérations suivantes :
- introduire ou faire défiler un substrat dans une chambre de réaction dans laquelle sont placées au moins deux électrodes positionnées de part et d'autre du substrat, au moins une barrière diélectrique étant placée entre ces au moins deux électrodes ;
- mettre en service une alimentation stabilisée en amplitude et en fréquence comprenant un transformateur très haute tension (THT) et haute fréquence (HF) comprenant un circuit secondaire aux bornes duquel les au moins deux électrodes sont reliées;
- engendrer dans le circuit secondaire de ce transformateur une tension électrique à haute fréquence stabilisée de valeur telle qu'elle entraîne la génération d'un plasma filamentaire dans la chambre de réaction, entre les au moins deux électrodes, le plasma étant composé d'électrons, d'espèces neutres, d'ions positif et négatif, d'espèces à l'état stable et excité ;

- mettre en service une alimentation de courant continu (DC) placée en série avec le transformateur THT/HF pour générer une tension continue qui se superpose à la tension alternative générée par le transformateur, de façon à augmenter la polarité du substrat et de diminuer la polarité de l'électrode ou réciproquement suivant la valeur de la tension alternative;
- introduire dans la chambre de réaction un mélange dont la composition est telle qu'au contact du plasma, il se décompose et engendre des espèces aptes à se déposer en couche en grande partie ou en totalité sur le substrat ;
- maintenir le substrat dans la chambre durant un laps de temps suffisant pour obtenir sur au moins une de ses faces une couche d'épaisseur souhaitée.

On notera que le procédé de l'invention est défini en termes d' « opérations » plutôt que d' « étapes », c'est à dire que la succession des opérations ne s'effectue pas obligatoirement dans l'ordre où elles sont énoncées ci-dessus.

La chambre de réaction peut-être un système fermé, tel que mis en oeuvre dans un procédé dit « off-line », ou ouvert, tel qu'un procédé dit « on-line » de dépôt en ligne de couches sur un substrat par exemple du verre.

Typiquement, les tensions électriques sont comprises entre 1 et 50 kV.

Habituellement, le mélange introduit dans la chambre de réaction comprend, sans pour autant être limités, des précurseurs gazeux organométalliques à base de Ti, Si, Zr, Sn et de Al, ou leur mélange, susceptibles de former des espèces aptes à se déposer pour former des couches métalliques ou d'oxydes métalliques sur le substrat. Le mélange peut également contenir d'autres substances, tels que des gaz vecteurs, des oxydants, de l'eau, des dopants d'oxydes métalliques à base de Sn, F, In, etc., en des proportions connues de l'homme du métier qu'il utilisera en fonction de la technologie de dépôt.

Les laps de temps sont généralement compris entre 1 s et 1 minute, de préférence entre 10 s et 50 s. Les épaisseurs de couches obtenues sont également variables, typiquement comprises entre quelques nanomètres et quelques centaines de nanomètres, typiquement entre 1 nm et 1000 nm.

Le procédé comprend en outre l'opération consistant à ajuster la valeur de la source DC de façon à ce que la tension alternative n'atteigne pas la valeur d'amorçage dans un des sens de la polarité.

Un autre objet de l'invention est un dispositif de traitement de surface d'un susbstrat par décharge à barrière diélectrique permettant la génération de plasma filamentaire comprenant une chambre de réaction comportant un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD placée entre ces au moins deux électrodes, et un transformateur THT/HF comportant un circuit secondaire, dans lequel une source de courant continu (DC) est intercalée en série dans le circuit secondaire, de façon telle que des espèces chimiques générées dans le plasma sous formes d'ions électriquement positifs ou négatifs soient sélectivement attirées par le substrat cible, lequel est introduit dans la chambre de réaction et placé entre les au moins deux électrodes, et repoussés par les électrodes de charge correspondante.

Par une telle disposition en série de la source de courant DC avec le circuit secondaire du transformateur, on évite la présence de selfs de blocage de la tension AC. Ceci présente notamment l'avantage de simplifier le montage électrique et donc de réduire les coûts de mise en oeuvre à l'échelle industrielle.

La source DC intercalée en série dans le circuit secondaire du transformateur THT/HF, dont les tensions DC sont de préférence comprises entre 1 kV et 15 kV, permet de réduire le dépôt non désiré sur l'électrode de 3% à 7%. Selon un mode de réglage avantageux, les tensions DC générées par la source DC sont comprises entre 15,1 kV et 100 kV, permettant une réduction du dépôt non désiré sur l'électrode d'au moins 7%.

A titre d'exemples particuliers, des valeurs de tensions DC comprises entre 20 et 100 kV, de façon plus préférées entre 20 et 80 kV, donnent des réductions de dépôts indésirables d'au moins 15%, en particulier d'au moins 35%. Spécifiquement, pour des tensions de 20, 40, 60, 80 kV, on obtient une réduction de dépôts respectivement de 15%, 25%, 30% et 35%.

La chambre de réaction peut-être un système fermé, tel que mis en oeuvre dans un procédé dit « off-line », ou ouvert, tel qu'un procédé dit « on-line » de dépôt en ligne de couches sur du verre par exemple. Le substrat peut donc défiler au travers de la chambre de réaction ou y être placé.

Suivant une forme de réalisation avantageuse, la source DC est obtenue à l'aide d'un circuit redresseur alimenté directement par une fraction de la tension HF prélevée au générateur THT/HF.

Le dispositif comprend de préférence un commutateur permettant de permuter les pôles positif et négatif afin de polariser l'électrode soit positivement soit négativement par rapport au substrat cible.

Des moyens d'ajustement de la tension de polarisation sont avantageusement prévus, tels que les potentiomètres, de façon telle que la dite tension ne permette plus l'amorçage du plasma que sur une demi alternance positive ou négative, la polarisation étant telle que le plasma génère les espèces chimiquement responsable du dépôt de couche que lorsque l'électrode est de signe contraire à ces dites espèces.

Les pôles de la source DC sont avantageusement court-circuités par une capacité dont l'impédance est au moins 1000 fois plus faible que celle constituée par la cellule de décharge, cette dernière ayant pour valeur typique de quelques centaines de pF.

Avantageusement, le dispositif comporte une capacité de blocage placée directement en série avec le transformateur afin d'éviter que la composante continue du courant ne puisse perturber le fonctionnement de ce transformateur THT/HF. De telles capacités de blocage ont des valeurs habituellement de quelques µF.

Un premier avantage du procédé et du dispositif de l'invention est que la diminution, voire l'élimination de dépôts parasites sur l'électrode portée à la haute tension, n'engendre pas de perturbation au niveau de la décharge plasma, telles que les modifications des constantes diélectriques et de l'espace inter-électrode, et qu'il n'est plus nécessaire d'interrompre le procédé afin de réaliser un nettoyage de l'électrode.

Un autre avantage du procédé de l'invention est que la polarisation de l'électrode portée à la haute tension permet d'appliquer un surcroît de tension sur l'alternance durant laquelle le dépôt de couche s'effectue sur le substrat. Ce surcroît de tension permet, pour une distance inter-électrode donnée, d'augmenter le rendement matière ainsi que les vitesses de dépôt. Il permet également, pour une vitesse de dépôt ou un rendement matière donnés, d'augmenter l'espace qui sépare les électrodes.

Le dispositif et le procédé de l'invention sont très avantageusement adaptés au dépôt de couches organiques et/ou inorganiques, tels que de métaux, d'oxydes métalliques et polymères, sur un substrat, tel que le verre flotté, c'est-à-dire appliqué « on-line » lors de la production du verre flotté, comme mentionné plus haut.

L'invention concerne également l'utilisation d'un dispositif de traitement de surface d'un substrat par décharge à barrière diélectrique, permettant la génération de plasma filamentaire, comprenant une chambre de réaction comportant un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD placée entre ces au moins deux électrodes, et un transformateur THT/HF comportant un circuit secondaire, dans lequel une source de courant continu (DC) est intercalée en série dans le circuit secondaire, pour réduire ou éliminer les dépôts indésirables sur l'électrode portée à la haute tension AC .

Très avantageusement, les tensions DC de la source DC sont comprises entre 20 et 100 kV, de façon plus préférée entre 20 et 80 kV, conduisant à des réductions de dépôts indésirables d'au moins 15%, en particulier d'au moins 35%.

L'invention concerne en outre l'utilisation d'un dispositif de traitement de surface d'un substrat par décharge à barrière diélectrique, permettant la génération de plasma filamentaire, comprenant une chambre de réaction comportant un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD placée entre ces au moins deux électrodes, et un transformateur THT/HF comportant un circuit secondaire, dans lequel une source de courant continu (DC) est intercalée en série dans le circuit secondaire, pour améliorer le rendement de procédés de dépôt de couches par augmentation de la tension sur l'alternance durant laquelle les espèces désirées se déposent sur le substrat..

Les caractéristiques préférentielles du dispositif définies ci-dessus s'appliquent également ici dans le cadre de l'utilisation dudit dispositif.

Ces aspects ainsi que d'autres aspects de l'invention sont décrits plus en détail ci-dessous référence étant faite aux dessins des figures, dans lesquelles :
- La Fig.1: est un schéma simplifié d'un mode de polarisation série ;
- La Fig.2: est un schéma simplifié d'un mode de polarisation avec prélèvement de tension sur le secondaire du transformateur et redressement ;
- La Fig. 3: est un graphique montrant l'effet de superposition des deux tensions continue et alternative.

Les figures ne sont pas dessinées à l'échelle. Généralement, des éléments semblables sont dénotés par des références semblables dans les figures.

L'invention concerne un procédé et un dispositif de polarisation en courant continu (DC) d'une cellule d'un dispositif de décharge à barrière diélectrique (DBD) permettant de réduire ou d'annuler tout dépôt non souhaité sur une des électrodes de cette cellule, par exemple d'au moins 15%, en particulier d'au moins 35% pour des tensions comprises entre 20 et 100 kV. L'électrode est utilisée pour la génération du plasma produisant des espèces chimiques sous formes d'ions électriquement positifs ou négatifs formant par déposition une couche sur un substrat cible, qui est, par exemple, un volume de verre.

Cette fonction peut être améliorée par une polarisation DC de l'électrode, ce qui permet de réduire ou d'annuler tout dépôt non souhaité sur la dite électrode. En effet, la polarisation de l'électrode portée à haute tension permet de repousser les charges électriques de même signe et donc de réduire la formation d'un dépôt non désiré sur cette électrode. En effet, dans ce cas, seules les espèces, en général des molécules ionisées, de signe opposé à celui de l'électrode sont attirées par celle-ci et peuvent s'y déposer, ce qui ralentit considérablement le dépôt non désiré.

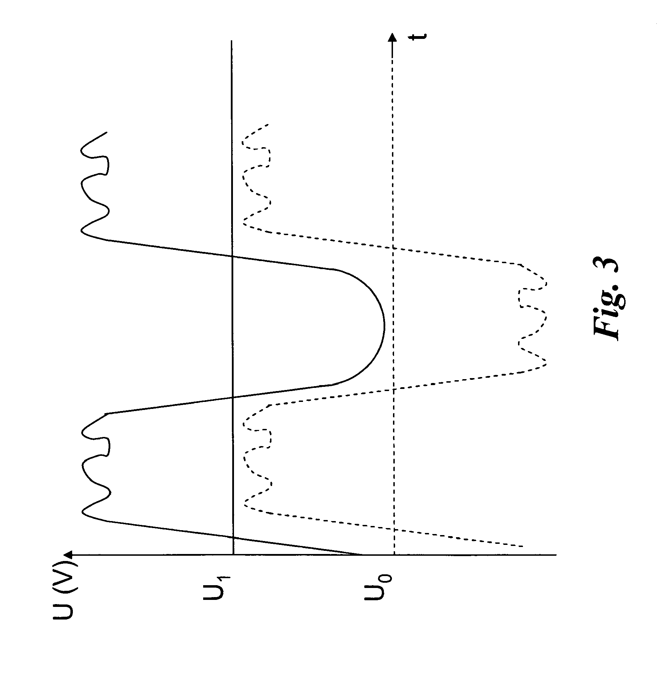

Comme montré à la Fig.3, la tension de polarisation peut être ajustée de sorte qu'elle ne permette plus l'amorçage du plasma que sur une demi alternance (positive ou négative). Ceci est rendu possible en appliquant une polarisation telle que la tension résultante entre l'électrode haute tension et la masse soit inférieure à la tension d'amorçage du plasma. Dès lors, il est possible d'éviter tout dépôt lié à la demi-alternance positive ou négative. Les espèces chimiques responsables du dépôt de couche n'étant plus générées pendant la demi-période durant laquelle elles sont attirées vers l'électrode, le dépôt parasite est pratiquement supprimé.

Cette polarisation est obtenue en intercalant en série dans le circuit secondaire du transformateur THT/HF une source DC de préférence comprise entre 1 kV et 15 kV et suivant un mode de réglage avantageux entre 15,1 kV et 100 kV. A titre d'exemples particuliers, des valeurs de tensions DC comprises entre 20 et 100 kV, de façon plus préférées entre 20 et 80 kV, donnent des réductions de dépôts indésirables d'au moins 15%, en particulier d'au moins 35%. Spécifiquement, pour des tensions de 20, 40, 60, 80 kV, on obtient une réduction respectivement de 15%, 25%, 30% et 35%.

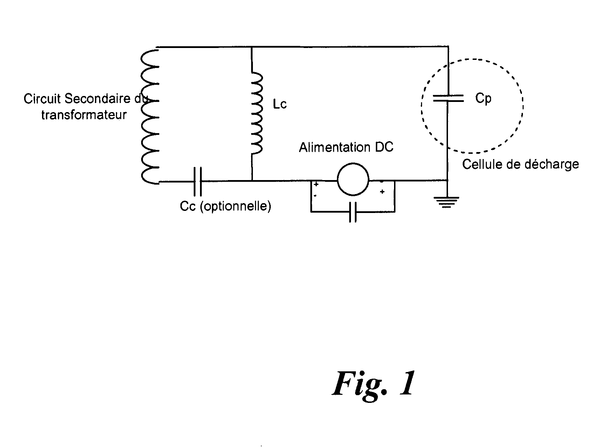

Plus précisément, la source DC est intercalée entre la masse, commune avec la mise à la terre, et la jonction « froide » du circuit secondaire du transformateur haute tension et de la self de compensation, comme montré à la Figure 1. Dans certaines situations, afin d'éviter que la composante continue ne puisse perturber le fonctionnement du transformateur haute tension THT/HF en provoquant la saturation magnétique de son noyau en ferrite, il est avantageux d'intercaler une capacité de blocage Cc placée directement en série avec le transformateur.

La source DC à des pôles flottants pour permettre, suivant les différents types de couche, une polarisation positive ou négative. Les pôles positif et négatif peuvent être commutés afin de polariser l'électrode soit positivement soit négativement par rapport au substrat cible. Les pôles de la source DC sont shuntés par une capacité dont l'impédance est au moins 1000 fois plus faible que la capacité de la cellule de décharge, qui est en fait l'équivalent électrique de la chambre à plasma où se déroulent les opérations de traitement de surface. La capacité en parallèle sur l'alimentation DC a une valeur telle que son impédance soit nettement inférieure à celle de la cellule de décharge afin de ne pas perturber le fonctionnement du circuit résonnant formé par le couplage entre la partie capacitive du système (Cp) et la partie inductive des selfs de compensation (Lc).

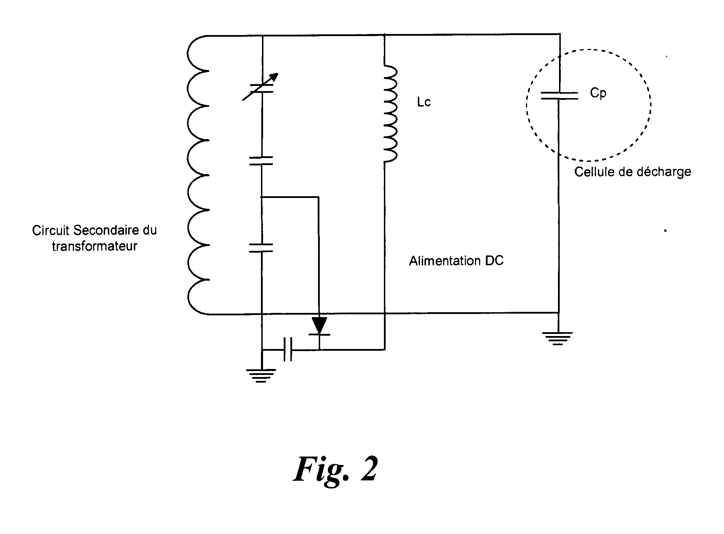

Dans le cas d'installations de forte puissance, nécessaires aux cadences de production élevée, il peut être avantageux de générer la tension DC de polarisation en prélevant une fraction de la tension haute fréquence. Comme cela est représenté à la Fig. 2, la source DC est obtenue à l'aide d'un circuit redresseur alimenté directement par une fraction de la tension THT/HF prélevée au générateur THT/HF.

Il apparaîtra évident pour l'homme du métier que la présente invention n'est pas limitée aux exemples illustrés et décrits ci-dessus. L'invention comprend chacune des caractéristiques nouvelles ainsi que leur combinaison telles qu'énoncées dans les revendications jointes. La présence de numéros de référence ne peut être considérée comme limitative. L'usage du terme « comprend » ne peut en aucune façon exclure la présence d'autres éléments autres que ceux mentionnés. L'usage de l'article défini « un » pour introduire un élément n'exclut pas la présence d'une pluralité de ces éléments. La présente invention a été décrite en relation avec des modes de réalisations spécifiques, qui ont une valeur purement illustrative et ne doivent pas être considérés comme limitatifs

## Revendications

1. Dispositif de traitement de surface d'un substrat par décharge à barrière diélectrique avec génération de plasma filamentaire, comprenant une chambre de réaction comportant, en fonctionnement, un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD) placée entre ces au moins deux électrodes, et un transformateur THT/HF comportant un circuit secondaire, dans lequel une source de courant continu (DC) est intercalée en série dans le circuit secondaire, de façon telle que des espèces chimiques générées dans le plasma sous formes d'ions électriquement positifs ou négatifs soient sélectivement attirées par le substrat cible, lequel est introduit dans la chambre de réaction et placé entre les au moins deux électrodes, et repoussés par les électrodes de charge correspondante.

2. Dispositif suivant la revendication 1, **caractérisé en ce que** la source DC intercalée dans le circuit HF du transformateur THT est comprise entre 1 kV et 15 kV.

3. Dispositif suivant la revendication 1, **caractérisé en ce que** les tensions DC générées par la source DC intercalée dans le circuit HF du transformateur THT sont comprises entre 15,1 et 100 kV.

4. Dispositif suivant la revendication 3, **caractérisé en ce que** les tensions DC générées par la source DC sont comprises entre 20 et 100 kV, de façon plus préférées entre 20 et 80 kV.

5. Dispositif suivant l'une quelconque des revendications précédente, **caractérisé en ce que** la source DC est obtenue à l'aide d'un circuit redresseur alimenté directement par une fraction de la tension THT/HF prélevée au générateur THT.

6. Dispositif suivant l'une quelconque des revendications précédentes, **caractérisé en ce qu'**il comprend un commutateur permettant de permuter les pôles positif et négatif afin de polariser l'électrode soit positivement soit négativement par rapport au substrat cible.

7. Dispositif suivant l'une quelconque des revendications précédentes, **caractérisé en ce qu'**il comprend des moyens d'ajustement de la tension de polarisation de façon telle que la dite tension ne permette plus l'amorçage du plasma que sur une demi alternance positive ou négative, la polarisation étant telle que le plasma génère les espèces chimiquement responsable du dépôt de couche que lorsque l'électrode est de signe contraire à ces dites espèces.

8. Dispositif suivant l'une quelconque des revendications précédentes, **caractérisé en ce que** les pôles de la source DC sont court-circuités par une capacité dont l'impédance est au moins 1000 fois plus faible que celle constituée par la cellule de décharge.

9. Dispositif suivant l'une quelconque des revendications précédentes, **caractérisé en ce qu'**il comporte une capacité de blocage placée directement en série avec le transformateur de façon à éviter que la composante continue du courant ne puisse perturber le fonctionnement de ce transformateur THT/HF.

10. Procédé pour le dépôt d'une couche sur un substrat inorganique, **caractérisé en ce qu'**il comprend les opérations suivantes :
- introduire ou faire défiler un substrat dans une chambre de réaction dans laquelle sont placées au moins deux électrodes positionnées de part et d'autre du substrat, au moins une barrière diélectrique étant placée entre ces au moins deux électrodes ;
- mettre en service une alimentation stabilisée en amplitude et en fréquence comprenant un transformateur très haute tension (THT) et haute fréquence (HF) comprenant un circuit secondaire aux bornes duquel les au moins deux électrodes sont reliées;
- engendrer dans le circuit secondaire de ce transformateur une tension électrique à haute fréquence stabilisée de valeur telle qu'elle entraîne la génération d'un plasma filamentaire dans la chambre de réaction, entre les au moins deux électrodes, le plasma étant composé d'électrons, d'espèces neutres, d'ions positif et négatif, d'espèces à l'état stable et excité ;
- mettre en service une alimentation de courant continu (DC) placée en série avec le transformateur THT/HF pour générer une tension continue qui se superpose à la tension alternative générée par le transformateur, de façon à augmenter la polarité du substrat et de diminuer la polarité de l'électrode ou réciproquement suivant la valeur de la tension alternative;
- introduire dans la chambre de réaction un mélange dont la composition est telle qu'au contact du plasma, il se décompose et engendre des espèces aptes à se déposer en couche en grande partie ou en totalité sur le substrat ;
- maintenir le substrat dans la chambre durant un laps de temps suffisant pour obtenir sur au moins une de ses faces une couche d'épaisseur souhaitée.

11. Procédé suivant la revendication 10, **caractérisé en ce qu'**il comprend en outre l'opération suivante :
- ajuster la valeur de la source DC de façon à ce que la tension alternative n'atteigne pas la valeur d'amorçage dans un des sens de la polarité.

12. Procédé selon la revendication 10 ou 11, **caractérisé en ce qu'**il comprend l'inversion de la polarité par rapport au substrat.

13. Utilisation d'un dispositif de traitement de surface d'un substrat par décharge à barrière diélectrique avec génération de plasma filamentaire, comprenant une chambre de réaction comportant, en fonctionnement, un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD) placée entre ces au moins deux électrodes, et un transformateur THT/HF comportant un circuit secondaire, dans lequel une source de courant continu (DC) est intercalée en série dans le circuit secondaire, pour réduire ou éliminer les dépôts indésirables sur l'électrode portée à la haute tension AC .

14. Utilisation selon la revendication 13, dans laquelle les tensions DC de la source DC sont comprises entre 20 et 100 kV, de façon plus préférées entre 20 et 80 kV, conduisant à des réductions de dépôts indésirables d'au moins 15%, en particulier d'au moins 35%.

15. Utilisation d'un dispositif de traitement de surface d'un substrat par décharge à barrière diélectrique avec génération de plasma filamentaire, comprenant une chambre de réaction comportant, en fonctionnement, un mélange dont la composition est telle qu'au contact du plasma il se décompose et engendre des espèces aptes à se déposer en couche en grande partie ou en totalité sur le substrat, chambre dans laquelle sont placées au moins deux électrodes dont l'une est portée à la haute tension AC, disposées de part et d'autre du substrat, au moins une barrière diélectrique (DBD) placée entre ces au moins deux électrodes, et un transformateur THT/HF comportant un circuit secondaire, dans lequel une source de courant continu (DC) est intercalée en série dans le circuit secondaire, pour améliorer le rendement de procédés de dépôt de couches par augmentation de la tension sur l'alternance durant laquelle les espèces désirées se déposent sur le substrat.

## Patentansprüche

1. Vorrichtung zur Behandlung der Oberfläche eines Substrats durch dielektrisch behinderte Entladung mit Erzeugung von Fadenplasma, umfassend eine Reaktionskammer, die während des Betriebs ein Gemisch umfasst, dessen Zusammensetzung derart ist, dass es sich beim Kontakt mit dem Plasma zersetzt und Spezies erzeugt, die geeignet sind, sich größtenteils oder vollständig als Schicht auf dem Substrat abzuscheiden, wobei in der Kammer mindestens zwei Elektroden untergebracht sind, von denen eine auf eine Wechselhochspannung gebracht wird, und die auf beiden Seiten des Substrats angeordnet sind, mindestens eine dielektrische Barriere (DBD), die während des Betriebs zwischen diesen mindestens zwei Elektroden untergebracht ist, und einen Höchstspannungs/Hochfrequenztransformator, der einen Sekundärkreis umfasst, in dem eine Gleichstromquelle (DC) in Reihe in dem Sekundärkreis zwischengeschaltet ist, derart, dass in dem Plasma in der Form von elektrisch positiven oder negativen Ionen erzeugte chemische Spezies selektiv durch das Zielsubstrat angezogen werden, das in die Reaktionskammer eingeführt und zwischen den mindestens zwei Elektroden untergebracht wird, und durch die Elektroden mit der entsprechenden Ladung abgestoßen werden.

2. Vorrichtung nach Anspruch 1, **dadurch gekennzeichnet, dass** die im Hochfrequenzkreis des Höchstspannungstransformators zwischengeschaltete Gleichstromquelle zwischen 1 kV und 15 kV umfasst ist bzw. liegt.

3. Vorrichtung nach Anspruch 1, **dadurch gekennzeichnet, dass** die Gleichstromspannungen, die im Hochfrequenzkreis des Höchstspannungstransformators durch die zwischengeschaltete Gleichstromquelle erzeugt werden, zwischen 15,1 und 100 kV umfasst sind bzw. liegen.

4. Vorrichtung nach Anspruch 3, **dadurch gekennzeichnet, dass** die durch die Gleichstromquelle erzeugten Gleichstromspannungen zwischen 20 und 100 kV, vorzugsweise zwischen 20 und 80 kV, umfasst sind bzw. liegen.

5. Vorrichtung nach einem der vorhergehenden Ansprüche, **dadurch gekennzeichnet, dass** die Gleichstromquelle mittels einer Gleichrichterschaltung erhalten wird, die direkt durch einen Teil der am Höchstspannungsgenerator abgegriffenen Höchst/Hochfrequenzspannung versorgt wird.

6. Vorrichtung nach einem der vorhergehenden Ansprüche, **dadurch gekennzeichnet, dass** sie einen Schalter umfasst, der das Vertauschen der positiven und negativen Pole ermöglicht, um die Elektrode entweder positiv oder negativ in Bezug auf das Zielsubstrat zu polarisieren.

7. Vorrichtung nach einem der vorhergehenden Ansprüche, **dadurch gekennzeichnet, dass** sie Mittel zur Einstellung der Polarisationsspannung umfasst, derart, dass die Spannung die Zündung des Plasmas nur noch während einer positiven oder negativen Halbperiode ermöglicht, wobei die Polarisation derart ist, dass das Plasma die Spezies, die chemisch für das Abschneiden der Schicht verantwortlich sind, nur dann erzeugt, wenn das Vorzeichen der Elektrode demjenigen dieser Spezies entgegengesetzt ist.

8. Vorrichtung nach einem der vorhergehenden Ansprüche, **dadurch gekennzeichnet, dass** die Pole der Gleichstromquelle durch eine Kapazität kurzgeschlossen sind, deren Impedanz mindestens 1000 Mal kleiner als diejenige ist, die durch die Entladungszelle gebildet ist.

9. Vorrichtung nach einem der vorhergehenden Ansprüche, **dadurch gekennzeichnet, dass** sie eine Sperrkapazität umfasst, die direkt in Reihe mit dem Transformator untergebracht ist, derart, dass verhindert wird, dass die Gleichstromkomponente den Betrieb dieses Höchstspannungs/Hochfrequenztransformators stören kann.

10. Verfahren zum Abscheiden einer Schicht auf einem anorganischen Substrat, **dadurch gekennzeichnet, dass** es die folgenden Arbeitsvorgänge umfasst:
- Einführen oder Vorbeilaufenlassen eines Substrats in einer Reaktionskammer, in der mindestens zwei Elektroden untergebracht sind, die auf beiden Seiten des Substrats positioniert sind, wobei mindestens eine dielektrische Barriere zwischen diesen mindestens zwei Elektroden untergebracht ist;
- Inbetriebnehmen einer amplituden- und frequenzstabilisierten Stromzuführung, die einen Höchstspannungs- und Hochfrequenztransformator umfasst, der einen Sekundärkreis umfasst, mit dessen Anschlussklemmen die mindestens zwei Elektroden verbunden sind;
- Erzeugen einer elektrischen Hochfrequenzspannung in dem Sekundärkreis dieses Transformators, deren Wert derart stabilisiert ist, dass sie die Erzeugung eines Fadenplasmas in der Reaktionskammer zwischen den mindestens zwei Elektroden bewirkt, wobei das Plasma aus Elektroden, neutralen Spezies, positiven und negativen Ionen und Spezies im stabilen und erregten Zustand besteht;
- Inbetriebnehmen einer Gleichstromzuführung (DC), die in Reihe mit dem Höchstspannungs/Hochfrequenztransformator untergebracht ist, um eine Gleichspannung zu erzeugen, die sich mit der durch den Transformator erzeugten Wechselspannung überlagert, derart, dass die Polarität des Substrats erhöht und die Polarität der Elektrode gemäß dem Wert der Wechselspannung verringert wird oder umgekehrt;
- Einführen eines Gemischs in die Reaktionskammer, dessen Zusammensetzung derart ist, dass es sich beim Kontakt mit dem Plasma zersetzt und Spezies erzeugt, die geeignet sind, sich als Schicht größtenteils oder vollständig auf dem Substrat abzuscheiden;
- Halten des Substrats in der Kammer während eines Zeitraums, der ausreicht, um auf mindestens einer seiner Seiten eine Schicht mit einer gewünschten Dicke zu erhalten.

11. Verfahren nach Anspruch 10, **dadurch gekennzeichnet, dass** es ferner den folgenden Arbeitsvorgang umfasst:
- Einstellen des Werts der Gleichstromquelle, derart, dass die Wechselspannung nicht den Zündwert in einer der Polaritätsrichtungen erreicht.

12. Verfahren nach Anspruch 10 oder 11, **dadurch gekennzeichnet, dass** es die Umkehrung der Polarität in Bezug auf das Substrat umfasst.

13. Verwendung einer Vorrichtung zur Behandlung der Oberfläche eines Substrats durch dielektrisch behinderte Entladung mit Erzeugung von Fadenplasma, umfassend eine Reaktionskammer, die während des Betriebs ein Gemisch umfasst, dessen Zusammensetzung derart ist, dass es sich beim Kontakt mit dem Plasma zersetzt und Spezies erzeugt, die geeignet sind, sich größtenteils oder vollständig als Schicht auf dem Substrat abzuscheiden, wobei in der Kammer mindestens zwei Elektroden untergebracht sind, von denen eine auf eine Wechselhochspannung gebracht wird, und die auf beiden Seiten des Substrats angeordnet sind, mindestens eine dielektrische Barriere (DBD), die während des Betriebs zwischen diesen mindestens zwei Elektroden untergebracht ist, und einen Höchstspannungs/Hochfrequenztransformator, der einen Sekundärkreis umfasst, in dem eine Gleichstromquelle (DC) in Reihe in dem Sekundärkreis zwischengeschaltet ist, um die unerwünschten Abscheidungen auf der auf die Wechselhochspannung gebrachten Elektrode zu verringern oder zu beseitigen.

14. Verwendung nach Anspruch 13, in der die Gleichstromspannungen der Gleichstromquelle zwischen 20 und 100 kV, vorzugsweise zwischen 20 und 80 kV, umfasst sind bzw. liegen, was zu Verringerungen der unerwünschten Abscheidungen um mindestens 15% und insbesondere um mindestens 35% führt.

15. Verwendung einer Vorrichtung zur Behandlung der Oberfläche eines Substrats durch dielektrisch behinderte Entladung mit Erzeugung von Fadenplasma, umfassend eine Reaktionskammer, die während des Betriebs ein Gemisch umfasst, dessen Zusammensetzung derart ist, dass es sich beim Kontakt mit dem Plasma zersetzt und Spezies erzeugt, die geeignet sind, sich größtenteils oder vollständig als Schicht auf dem Substrat abzuscheiden, wobei in der Kammer mindestens zwei Elektroden untergebracht sind, von denen eine auf eine Wechselhochspannung gebracht wird, und die auf beiden Seiten des Substrats angeordnet sind, mindestens eine dielektrische Barriere (DBD), die während des Betriebs zwischen diesen mindestens zwei Elektroden untergebracht ist, und einen Höchstspannungs/Hochfrequenztransformator, der einen Sekundärkreis umfasst, in dem eine Gleichstromquelle (DC) in Reihe in dem Sekundärkreis zwischengeschaltet ist, um den Wirkungsgrad von Verfahren zur Abscheidung von Schichten durch Erhöhung der Spannung während des Wechsels, während dessen die erwünschten Spezies sich auf dem Substrat abscheiden, zu verbessern.

## Claims

1. Device for treating the surface of a substrate by dielectric barrier discharge with generation of filament plasma, comprising a reaction chamber having in operation a mixture, the composition of which is such that on contact with the plasma it decomposes and develops species that are capable of being deposited, in large part or in their entirety, in layers on the substrate, and positioned in said chamber are at least two electrodes arranged on either side of the substrate, one of which electrodes being held at high AC voltage, at least one dielectric barrier (DBD) positioned between these at least two electrodes and a VHV/HF transformer having a secondary circuit, in which a direct current (DC) source is connected in series in the secondary circuit such that chemical species generated in the plasma in the form of electrically positive or negative ions are selectively attracted by the target substrate, which is inserted into the reaction chamber and positioned between the at least two electrodes, and are repelled by the electrodes of corresponding charge.

2. Device according to claim 1, **characterised in that** the DC source connected into the HF circuit of the VHV transformer ranges between 1 kV and 15 kV.

3. Device according to claim 1, **characterised in that** the DC voltages generated by the DC source connected into the HF circuit of the VHV transformer range between 15.1 kV and 100 kV.

4. Device according to claim 3, **characterised in that** the DC voltages generated by the DC source range between 20 and 100 kV, more preferred between 20 and 80 kV.

5. Device according to any one of the preceding claims, **characterised in that** the DC source is obtained by means of a rectifier circuit supplied directly by a fraction of the VHV/HF voltage drawn from the VHV transformer.

6. Device according to any one of the preceding claims, **characterised in that** it comprises a switch that allows switchover of the positive and negative poles in order to bias the electrode positively or negatively in relation to the target substrate.

7. Device according to any one of the preceding claims, **characterised in that** it comprises means for adjusting the bias voltage so that said voltage then only allows plasma ignition on a positive or negative half cycle, wherein the bias is such that the plasma generates species that are chemically responsible for the layer deposition when the sign of the electrode is contrary to these said species.

8. Device according to any one of the preceding claims, **characterised in that** the poles of the DC source are short-circuited by a capacitor, the impedance of which is at least 1000-times less than that formed by the discharge cell.

9. Device according to any one of the preceding claims, **characterised in that** it comprises a blocking capacitor positioned directly in series with the transformer in order to prevent the continuous component of the current from being able to interfere with the operation of this VHV/HF transformer.

10. Process for the deposition of a layer onto an inorganic substrate, **characterised in that** it comprises the following operations:
• inserting or passing a substrate into a reaction chamber, in which at least two electrodes are positioned on either side of the substrate, and at least one dielectric barrier is positioned between these at least two electrodes;
• putting into operation a power supply that is stabilised in amplitude and frequency comprising a very high voltage (VHV) and high frequency (HF) transformer comprising a secondary circuit with at least two electrodes connected to the terminals thereof;
• generating in the secondary circuit of this transformer a high frequency electric voltage stabilised in value such that it causes the generation of a filament plasma in the reaction chamber between the at least two electrodes, wherein the plasma is composed of electrons, neutral species, positive and negative ions, stable-state species, and stimulated;
• putting into operation a direct current (DC) supply positioned in series between the VHV/HF transformer to generate a direct current voltage superposed on the alternating voltage generated by the transformer in order to increase the polarity of the substrate and reduce the polarity of the electrode, or the reverse, according to the value of the alternating voltage;
• inserting into the reaction chamber a mixture with a composition, which is such that on contact with the plasma it decomposes and develops species that are capable of being deposited, in large part or in their entirety, in layers on the substrate;
• keeping the substrate in the reaction chamber for a sufficient period of time to obtain a layer with the desired thickness on at least one of its faces.

11. Process according to claim 10, **characterised in that** it additionally comprises the following operation:
• adjusting the value of the DC source so that the alternating voltage does not reach the ignition value in one of the directions of polarity.

12. Process according to claim10 or 11, **characterised in that** it includes the inversion of polarity in relation to the substrate.

13. Use of a device for treating the surface of a substrate by dielectric barrier discharge with generation of filament plasma, comprising a reaction chamber having in operation a mixture, the composition of which is such that on contact with the plasma it decomposes and develops species that are capable of being deposited, in large part or in their entirety, in layers on the substrate, and positioned in said chamber are at least two electrodes, arranged on either side of the substrate, one of which electrodes being held at high AC voltage, at least one dielectric barrier (DBD) positioned between these at least two electrodes and a VHV/HF transformer having a secondary circuit, in which a direct current (DC) source is connected in series in the secondary circuit to reduce or eliminate undesirable deposits on the electrode held at high AC voltage.

14. Use according to claim 13, in which the DC voltages of the DC source range between 20 and 100 kV, more preferred between 20 and 80 kV, leading to reductions in undesirable deposits of at least 15%, in particular at least 35%.

15. Use of a device for treating the surface of a substrate by dielectric barrier discharge with generation of filament plasma, comprising a reaction chamber having in operation a mixture, the composition of which is such that on contact with the plasma it decomposes and develops species that are capable of being deposited, in large part or in their entirety, in layers on the substrate, and positioned in said chamber are at least two electrodes arranged on either side of the substrate, one of which electrodes being held at high AC voltage, at least one dielectric barrier (DBD) positioned between these at least two electrodes and a VHV/HF transformer having a secondary circuit, in which a direct current (DC) source is connected in series in the secondary circuit to improve the yield of layer deposition processes by increasing the voltage on the alternating cycle, during which the desired species are deposited on the substrate.
